# EUROPEAN PATENT APPLICATION

(11) **EP 4 722 738 A1**
(43) Date of publication of application: **08.04.2026**
(21) Application number: 24810513.2
(22) Date of filing: 19.04.2024
(51) Int. Cl.: G01R 19/00, G01R 15/18, G01R 33/09, G01R 15/20

(54) **ELECTRONIC DEVICE FOR MEASURING ELECTRICAL CURRENT BY MEANS OF GALVANIC ISOLATION**

(30) Priority: 25.05.2023 ES 202330409
(71) Applicant: Universitat de Valéncia, 46010 Valencia (ES)
(72) Inventor: RAMÍREZ MUÑOZ, Diego, 46010 VALENCIA Valencia (ES)
(74) Representative: Temiño Ceniceros, Ignacio
(86) International application number: PCT/ES2024/070242
(87) International publication number: WO 2024/240972

(57) **Abstract**

A device for measuring electric current by means of non-dissipative galvanic isolation, with offset adjustment and current biasing using a triple voltage-to-current converter, comprising:
a first sensing subsystem comprising at least one magnetoresistor configured as a sensing element configured to provide galvanic isolation from an electric current to be measured;
a second subsystem comprising a resistor through which a current flows according to the value having a gain and a control voltage;
a third subsystem comprising an offset adjustment resistor through which the current determined in the second subsystem flows, which makes it possible to compensate for any eventual imbalance existing in the sensing element at zero measured current; and
a fourth subsystem consisting of a processor providing a voltage signal proportional to the electric current to be measured.

## Description

### TECHNICAL FIELD

The present invention relates to an electronic device for measuring electric current by means of non-dissipative galvanic isolation, with offset adjustment and current biasing using a triple voltage current-to-current converter. More specifically, the present invention relates to an electronic device for measuring electric current by means of galvanic isolation which is based on the use of a magnetoresistor which changes its value as a function of the current to be measured and through which a current generated by a triple voltage-to-current (VII) converter is passed, enabling the same current to be generated in three different branches from a control voltage, where one of the branches through which the generated current flows makes it possible to compensate for the unbalances associated with a sensing element, while the second branch produces a constant current biasing, and the third branch is used to measure the voltage drop produced in the magnetoresistor.

### State of the art

Current technologies for measuring electric current are mainly based on: current transformer, shunt resistor, Hall effect, Rogowsky-Chattock probe and magnetoresistive technology.

Current transformers require a magnetic core on which a large number of secondary windings are arranged. The primary consists basically of the conductor through which the current to be measured flows. The load resistance connected to its secondary must be well below the value of the output impedance of the secondary. It has galvanic isolation inherent to the measurement method being of relatively high volume when the frequency of the current to be measured is low. Due to their nature, they do not process direct currents, [1], [2], [3], [4], [5].

Shunt technology is the most conventional, [5], [7], [8], [9], [11], and it consists of passing the electric current of interest i(t) through a resistor of a certain value and using Ohm's Law to process the voltage drop between its terminals. This method of measurement does not offer galvanic isolation, so if one of the two terminals of the resistor is at a high potential, this aspect must be taken into account because of the eventual consequences it could have on the subsequent stages. Especially since it will require that the subsequent conditioning stage has a sufficiently high common mode voltage. The conditioning of the voltage V(t) at the shunt resistor is performed by a differential input voltage/voltage converter stage. For example, a differential amplifier with sufficient input impedance or an instrumentation amplifier, either in their DC or AC version. Commercially, there are also conditioning via voltage-to-current conversion. The state of the art shows possible real-life embodiments of discrete shunt resistors [11] as well as shunt resistors external to the conditioner [12] or sharing the same semiconductor substrate as the subsequent conditioning stage (differential voltage amplifier) [13].

Hall-type technologies are based on the Hall effect. This effect was discovered by the North American physicist E. C. Hall in 1879. The Hall effect is a direct consequence of the application of the Lorentz force to electric charge carriers and was first observed in metals. Currently, semiconductor materials and certain components derived from transition metals are preferentially used for the manufacturing of sensor elements. The first development in this direction is due to G. L. Pearson in 1947. Since then, sensors based on the Hall effect have found numerous applications in various fields of the art. Hall elements are incorporated into an integrated circuit through the integration of four elements connected together forming a Wheatstone bridge. In this way it is possible to minimise the imbalance stresses associated with each Hall element separately. These stresses are due to variations in the Hall element manufacturing process, temperature gradients in the substrate itself and mechanical stresses imposed by the potting process. Sensors based on the Hall effect are used, among other applications, for the design of current or magnetic field probes, [4], [5], [6], [8], [14], [15], [16], [17], [18], [19].

An immediate application is the measurement of magnetic fields (gaussmeters), current (ammeters) or in power measurement (wattmeter design) due to the proportionality between Hall voltage and power. Some manufacturers of current sensors based on the Hall effect are Honeywell, [17], Allegro Microsystems, [18] or LEM, [19]. Hall current sensors need a ferrite core to generate the necessary magnetic field, which in most cases makes them relatively bulky and heavy. The electronic circuitry on which their electronic conditioning is based may generally require relatively high current consumption. On the other hand, by the measuring principle itself, they already provide galvanic isolation from the conditioning electronics.

The Rogowsky-Chattock probe structure comprises a Rogowsky-Chattock inductor, [5], [6], [14], [20], [21], [22]. Firstly, it has a turn that runs from start to finish across the support on which the various windings of the inductor are arranged. These turns are wound in the opposite direction to that of the preceding winding. In this way, the voltages induced by magnetic fields passing through the inductor are compensated. On the other hand, it has been observed experimentally that the conductor whose current is to be measured must be located in the central part of the surface defining the inductor around it. In this way an optimum accuracy (±0.5 %) is achieved. Otherwise, as the conductor is placed closer to the inductor the accuracy degrades to values of ±4 %. On the other hand, it is not advisable to place the conductor in the closing area of the winding ends, as in this case the accuracy is not acceptable. On the other hand, and in accordance with Ampère's Law, it is not necessary that the windings that encircle the conductor do so in a circular path; what is important is that the path is closed.

Rogowsky-Chattock inductors have a number of properties that make them very interesting from a practical point of view if large levels of time-varying current (several kA) are intended to be measured. This is primarily due to the impossibility of saturation as they are implemented on air as a magnetic core. This feature gives them great linearity for a wide range of currents to be measured (0.1 % with currents of 1.5 kA). On the other hand, they feature galvanic isolation inherent to their mechanical construction and a very wide frequency response (from 0.1 Hz to 17 MHz). In contrast, they are not capable of measuring constant currents over time. In this type of sensor, the induced voltage is directly proportional to the time derivative of the current being measured. In order to recover the current, I(t), further processing is necessary, which basically consists of integrating the induced voltage.

Applications of the Rogowsky-Chattock inductor are primarily aimed at measuring large levels of current, especially transients, although they have also been used for monitoring sinusoidal current. For example, applications have been described for monitoring transients in high-power generators, arc production in furnaces, simulating atmospheric discharges, or energy consumption metering.

Magnetoresistive technology is based on the Biot-Savart Law whereby an electric current I(t) flowing through a conductor generates a magnetic field proportional to it. In this case the magnetic field sensitive material changes its electrical resistance with the magnetic field strength, [24], [6], [25], [26], [27], [28], [29]. The magnetoresistive current sensors are configured as a Wheatstone bridge in which four sensing magnetoresistor are arranged, two increasing in value with the field and two decreasing in value, thus achieving the required linearity. This technology inherently offers galvanic isolation due to its measuring principle, whether having a magnetic core or not. Some embodiments of magnetoresistive current sensors are shown in [30], [31].

Document GB2199411A discloses an alternating current metre, such as electricity metres, which are widely used in consumer supply lines to monitor power consumption and generally consist of rotating parts driven by induced magnetic fields or solid-state current sensing devices with temperature-compensated precision amplifiers and several adjustment potentiometers. Rotating parts in the first case cause wear and tear and give raise to errors and in the latter type, temperature variations cause problems as well as ageing of components and change of value. According to this document, a solid-state AC current metre can be manufactured that is not subject to ageing problems, nor does it require potentiometers to eliminate offsets above the zero current position. For this purpose, it uses, for example, a Hall or magnetoresistance sensor that is compensated for long-term stability and does not require potentiometer adjustments to eliminate compensation conditions. An automatic compensation feedback amplifier corrects drift with the aid of a capacitor and a resistor that have a long time constant. The output of the automatic compensation feedback amplifier is coupled to one of the inputs of the external amplifier using a fixed-value resistor, which will not allow a valid adjustment for all temperatures.

Document US2015069997 uses a method for manufacturing a current sensor that includes a current measurement circuit configured to include magnetoelectric conversion elements connected in a Wheatstone bridge, a first amplification and correction circuit configured to amplify an output of the current measurement circuit and correct a temperature characteristic of an offset based on a first set correction amount, a second amplification and correction circuit configured to amplify an output of the first amplification and correction circuit, adjust a sensitivity, and correct a magnitude of the offset based on a second set correction amount, and a substrate on which the current measurement circuit, the first amplification and correction circuit, and the second amplification and correction circuit are provided, in which the second correction amount is set after the first correction amount is set based on the characteristics of the magnetoelectric conversion elements. The document presents a complex compensation mechanism based on two cascaded electronic compensation systems: the first to compensate for the thermal drift of the sensor imbalance, and the second to compensate for the residual offset of the assembly formed by the sensor and the first compensation system, without specifying a compensation mechanism for the thermal drift of the sensor sensitivity. In addition, the sensor used in its various arrangements is supplied with a constant voltage, which will produce higher temperature coefficients than if the sensor were supplied with constant current. The proposed device offers simple compensation mechanisms for both the offset imbalance of the sensor and its thermal drift, as well as for the thermal drift that the sensor's sensitivity may have. On the other hand, since the sensor is powered at constant current, its possible temperature coefficients will be smaller in magnitude than the counterparts obtained with a constant voltage supply.

Finally, document US2020033384 describes a current sensor that provides an output signal in accordance with a signal magnetic field that is generated by a current to be measured. In the current sensor, the four magnetoresistance elements form a Wheatstone bridge circuit. The current sensor includes at least one magnetic sensor, a temperature sensor, an amplifier and a compensation adjustment circuit. The magnetic sensor generates a sensor signal in accordance with the magnetic field of the signal. The temperature sensor detects an ambient temperature. The amplifier amplifies the sensor signal at an amplification rate proportional to the detected temperature and generates the output signal. The compensation adjustment circuit adjusts an output signal compensation. The compensation adjustment circuit adjusts a compensation according to a relationship (mathematical expression) that is maintained between an output signal under a magnetic field without a signal and an amplification rate corresponding to the temperature.

However, in none of the above-mentioned documents is current measurement carried out using a single magnetoresistor. Nor would they have an electronic device for measuring electric current by means of a non-dissipative galvanic isolation with offset adjustment and current biasing using a triple voltage-to-current converter, according to the claims accompanying the present patent specification.

### Description of the invention

An object of the present invention is an electronic device for measuring electric current by means of a non-dissipative galvanic isolation, with offset adjustment and current biasing using a triple voltage-to-current converter. This object is achieved with the device of claim 1.

More specifically, the object of the invention is achieved by means of a device for measuring electric current by means of galvanic isolation comprising: (a) a first sensing subsystem comprising at least one resistor configured as a sensing element configured to provide galvanic isolation from an electric current to be measured; a second subsystem comprising a resistor through which a current flows according to the value having a gain and a control voltage; a third subsystem comprising an offset adjustment resistor through which the current determined in the second subsystem flows, which makes it possible to compensate for any eventual existing imbalance associated with the value of the sensing element at zero measured current; and a fourth subsystem providing a voltage signal proportional to the current of interest.

The proposed electronic system for measuring electric current offers inherent galvanic isolation. On the other hand, as the sensor is not traversed by the electric current to be measured (ILOAD), no self-heating occurs due to it, properties that the technology based on a resistive shunt lacks. All the remaining technologies (current transformer, Hall, Rogowsky-Chattock, and magnetoresistive) offer galvanic isolation without causing self-heating. However, the current transformer and the Rogowsky-Chattock probe do not offer a DC response, whereas the present invention would.

Hall and magnetoresistive technologies are usually based on Wheatstone bridge structures and so far, it is not usual to use single sensing elements. The proposed system requires only one sensing element and therefore offers simplicity in microelectronic manufacture (a single element) as the number of steps in the manufacture of one element would be less than four elements connected in Wheatstone bridge, as well as a reduction in the internal layout of its connections. From the electronic point of view, the system offers the possibility of compensating for both the offset (its response at zero current) and the eventual thermal drift that the sensing element might have, through an adjustment network included in the internal structure of the voltage-to-current converter itself. In this way, an explicit adjustment for this purpose would not be necessary in subsequent stages.

Throughout the description and in the claims, the word "comprises" and its variants are not intended to exclude other technical features, additives, components or steps. For those skilled in the art, other objects, advantages and features of the invention may be deduced from both the invention and the practical use of the invention. The following examples and drawings are provided by way of illustration and are not intended to limit the present invention. Furthermore, the invention covers all possible combinations of particular and preferred embodiments included herein.

### Brief description of the drawings

A very brief description of a series of drawings that aid in better understanding the invention, and which are expressly related to an embodiment of said invention that is illustrated by way of a non-limiting example of the same, is provided below.
- FIGURE 1: shows a diagram of the electronic device for measuring electric current according to the present invention.
- FIGURE 2: shows the electronic schematic of a possible practical embodiment of the electronic device according to the present invention.

### Detailed description of a practical embodiment of the invention

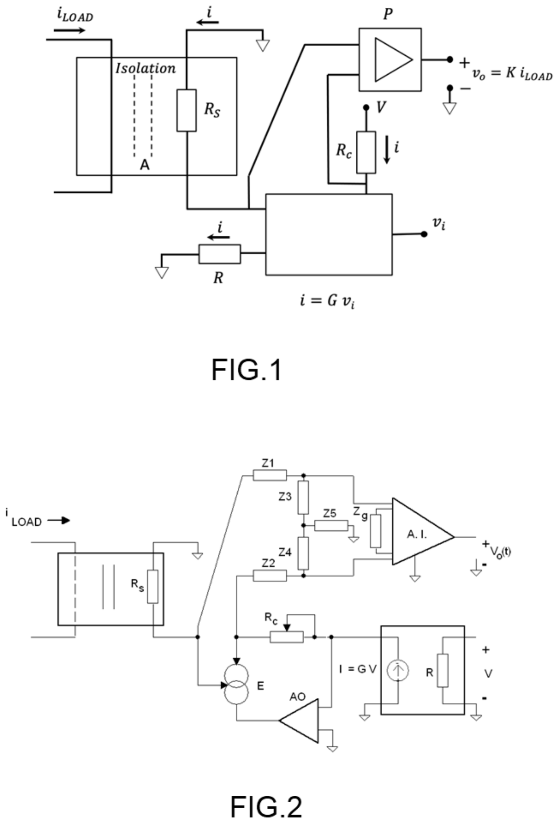

As can be seen in the attached figures, and particularly in figure 1, an electronic device is presented that is capable of generating the same current (I) in three subsystem branches (R_{C}, R_{S}, R) of the device by means of a control voltage (V_{I}). It is therefore a triple voltage-to-current converter. In a practical embodiment, the device is employed for measuring electric current by means of non-dissipative galvanic isolation, which allows the unbalances associated with a sensing element (R_{S}) and where said sensing element (R_{S}) is biased at constant current (I), although it would also find application for measuring other variables such for example as temperature, pressure, mechanical load, etc., through the use of other resistive sensors.

Fig.1 shows that the device of the invention is composed of four different subsystems.

The first subsystem is the sensing subsystem, represented by a resistor configured as a sensing element (R_{S}) which provides isolation from the electric current to be measured (I_{LOAD}). The second subsystem is represented by a resistor (R) through which a current (I) flows according to the value having the gain (G) of the voltage-to-current converter circuit forming this second subsystem and the control voltage (V_{I}). The third subsystem consists of an offset adjustment resistor (R_{C}) through which the current (I) determined in the second subsystem flows, which makes it possible to compensate for any eventual imbalance existing in the sensing element (R_{S}) at zero measured electric current. The fourth subsystem consists of a processor (P) which provides a voltage signal (V₀) proportional to the current (I_{LOAD}) of interest.

In this particular case, the gain (G) of the second subsystem (a voltage-to-current converter) G is the transconductance of the voltage-to-current converter and in this non-limiting example is the inverse of the resistance R (G = 1/R). In other voltage-to-current converters there are different formulas for the gain (G) of the converter.

The electronic device for measuring electric current comprises a galvanic isolation (A) due to the existence of a physical separation between the copper track through which the electric current to be measured (I_{LOAD}) flows and the position of the current sensor, or sensing element (R_{S}). Typically, the copper track is located on the lower part of a printed circuit board (PCB) or insulating hardware and the sensor is arranged on upper part thereof (component side), in a non-limiting practical realisation.

On the other hand, when measuring the electric current, the electronic device is non-dissipative as the current to be measured (I_{LOAD}) does not pass through the sensing element (R_{S}) and therefore does not cause any heating losses due to the Joule effect or self-heating of the latter. The electronic device makes it possible to compensate for the offset that the sensing element (R_{S}) may have, as well as for its biasing level at constant current (I) and its eventual thermal drift.

Figure 2 shows a practical example for the implementation of the device proposed in Figure 1.

In Figure 2 a current sensing element (R_{S}) based on magnetoresistive technology is displayed. In this case it is a single resistive element (as opposed to the more usual Wheatstone bridge) which provides galvanic isolation and no self-heating dissipation associated with the electric current to be measured (I_{LOAD}). All of this comprises the so-called first subsystem of Figure 1 above. The triple voltage-to-current conversion is implemented by means of the current mirror (E), the operational amplifier AO, the current source I whose value is controlled by the voltage V and the parameter G whose value, in turn, is determined by the value of the resistor R. In this way it is possible to select a current I which will be transferred to bias the sensing element (R_{S}) with a constant current. All these comprise the so-called second subsystem, in accordance with what is mentioned in Figure 1. The component R_{C} arranged in the feedback loop of the operational amplifier (AO) comprises the third subsystem mentioned in Figure 1. The R_{C} component, although arranged in a feedback loop of the operational amplifier (AO), does not influence the value of the selected current (I) due to the virtual short-circuit of the operational amplifier (AO). However, this allows to compensate for the eventual imbalance associated with the value of the sensing element (R_{S}) at zero measured current, i.e., when I_{LOAD}=0.

The stage consisting of components Z1, Z2, Z3, Z4 and Z5 blocks any DC frequency components that may exist in the sensor response. The Zg component and the instrumentation amplifier (I.A.) condition the current measured by the sensing element (R_{S}) to an appropriate voltage level. Components Z1, Z2, Z3, Z4, Zg and the instrumentation amplifier I.A. comprise the fourth processing subsystem P as described in connection with Figure 1. The signal provided by the processor subsystem at Vo(t) is proportional to the existing voltage difference between terminals of the sensing element (R_{S}) in the manner of a conventional shunt resistor. However, given its isolating and non-dissipative properties, which are provided by its magnetoresistive technology, it is appropriate for the concept to be referred as a magnetoresistive shunt.

The possible thermal drift associated with the sensing element could be compensated by the usual compensation techniques (hardware or software). The proposed system allows for hardware compensation, and if software compensation were intended, a data processing unit with instructions configured to this end would need to be added to the proposed system.

Finally, the present invention is applicable in multiple areas, in general, all those where electric current measurement is required such as: the photovoltaic sector (solar inverters), energy consumption metering, battery charge management, consumer electronics, switched-mode power supplies, and/or the control of motors and AC drives.

### References

[1] Wikipedia, https://en.wikipedia.org/wiki/Current_transformer
[2] Elkor, Introduction to Current Transformers, https://web.archive.org/web/20171118025817/http://www.elkor.net/pdfs/AN0305-Current_Transformers.pdf
[3] https://www.electronics-tutorials.ws/transformer/current-transformer.html
[4] Hioki, Current Sensing Methods, https://hiokiusa.com/6-current-sensing-methods/
[5] Mehrdad Biglarbegian; Shahriar Jalal Nibir; Hamidreza Jafarian; Babak Parkhideh, Development of current measurement techniques for high frequency power converters, 2016 IEEE International Telecommunications Energy Conference (INTELEC)
[6] Cristian MusÇuroi, Mihai Oproiu, Marius Volmer, loana Firastrau, High Sensitivity Differential Giant Magnetoresistance (GMR) Based Sensor for Non-Contacting DC/AC Current Measurement, Sensors 2020, 20, 323.
[7] Zhen, Y., Current Sensing Circuit Concepts and Fundamentals, Microchip Technology Inc. AN1332, 2011.
[8] Wikipedia, Current sensing, https://en.wikipedia.org/wiki/Current_sensing
[9] Martini, L. DC Energy Metering Applications, Analog Dialogue, vol. 55, n 1, February 2021.
[10] Tim Regan, Jon Munson, and Greg Zimmer, AN-105: Current Sense Circuit Collection Making Sense of Current, https://www.analog.com/en/app-notes/an-105fa.html
[11] Riedon, Precision current resistor, https://riedon.com/media/pdf/RS.pdf.
[12] https://www.ti.com/product/INA296A
[13] https://www.ti.com/product/INA250-Q1
[14] Ziegler, S.; Woodward, R. C.; lu, H. H. C.; Borle, L. J. (1 April 2009). "Current Sensing Techniques: A Review". IEEE Sensors Journal. 9 (4): 354-376.
[15] https://www.rfwireless-world.com/Terminology/Shunt-Resistor-Current-Sensing-vs-Hall-Effect-Current-Sensing.html
[16] Emerald, P., Non-Intrusive Hall-Effect Current Sensing Techniques Provide Safe, Reliable Detection and Protection for Power Electronics, Allegro MicroSystems, May 27, 2022.
[17] https://buildings.honeywell.com/us/en/products/by-category/sensors/current-sensors
[18] https://www.allegromicro.com/en/products/sense/current-sensor-ics
[19] https://www.lem.com/en/product-list?measurement=52
[20] Ward D.A., Exon J.T., Using Rogowski coils for transient current measurements, https://www.coilws.com/Current%20Sense/App1_rogowski.pdf
[21] Pem, Application Notes, Power Electronic Measurements Ltd. www.pemuk.com, 2008. http://www.pemuk.com/userfiles/cwt/cwt%20-%20technical%20notes%20-%20001.pdf
[22] Pem, Application Notes, LFR: flexible, clip-around current probe for use in power measurements, http://www.pemuk.com/Userfiles/LFR/LFR%20Technical%20Notes%20-%20001(NoLogo).pdf
[23] https://aimdynamics.com/rogowski-coils/
[24] NVE (Non Volatile Electronics), Engineering and application notes: giant magnetoresistive (GMR) sensors, www.nve.com.
[25] Non volatile electronics (NVE), https://www.nve.com/Videos/40A.mp4
[26] Non volatile electronics (NVE), https://www.nve.com/Videos/ACT001.mp4
[27] Daniel A. Baker, "Isolation Technology Increases Density and Reliability (.pdf)," Electronic Specifier Power, January 2015.
[28] Hermann, T. M, Magnetically coupled linear isolator, Ieee, Trans. Magn, vol. 33, n. 5, sept. 1997
[29] Analog-signal isolation, EDN, June 4, 1998.
[30] Sensitec Magnetoresistive Sensors, https://www.sensitec.com/products-solutions/current-measurement/cas5000-family-new
[31] https://sps.honeywell.com/us/en/products/advanced-sensing-technologies/aero- and-transportation-sensing/aero-and-transportation-sensors/current-sensors/closed-loop-current-sensors/csng-series

## Claims

1. A device for measuring electric current by means of non-dissipative galvanic isolation, with offset adjustment and current biasing using a triple voltage-to-current converter, comprising:
a first sensing subsystem comprising at least one magnetoresistor configured as a sensing element (R_{S}) configured to provide galvanic isolation (A) from an electric current to be measured (I_{LOAD});
a second subsystem comprising a resistor (R) through which a current (I) flows according to the value having a gain (G) and a control voltage (V_{I});
a third subsystem comprising an offset adjustment resistor (R_{C}) through which the current (I) determined in the second subsystem flows, which makes it possible to compensate for any eventual imbalance existing in the sensing element (R_{S}) at zero measured current; and
a fourth subsystem consisting of a processor providing a voltage signal (Vₒ) proportional to the electric current (I_{LOAD}) to be measured.

2. The device according to claim 1 wherein the galvanic isolation (A) consists of a physical separation between a conductor through which the electric current to be measured (I_{LOAD}) flows and the position of the current sensor or sensing element (Rs).

3. The device according to claim 1 or 2 wherein the current to be measured (I_{LOAD}) does not flow through the sensing element (R_{S}) and therefore does not cause Joule heating losses or self-heating of the sensing element.

4. The device according to claim 1 or 2 wherein it is possible to perform thermal compensation of the sensor (Rs) sensitivity in the processor contained in the fourth subsystem.
